# EUROPÄISCHE PATENTSCHRIFT

(11) **EP 3 271 497 B1**
(45) Veröffentlichungstag und Bekanntmachung des Hinweises auf die Patenterteilung: **07.09.2022**
(21) Anmeldenummer: 16713290.1
(22) Anmeldetag: 15.03.2016
(51) Int. Cl.: C23C 16/26, C23C 14/06, C23C 14/32, C23C 14/34, H01J 37/34, C01B 32/05, C01B 32/984, H01J 37/32

(54) **BESCHICHTUNGSQUELLE UND VERFAHREN ZUR HERSTELLUNG DOTIERTER KOHLENSTOFFSCHICHTEN**
COATING SOURCE AND METHOD FOR PRODUCING DOPED CARBON LAYERS
SOURCE DE REVÊTEMENT ET PROCÉDÉ DESTINÉE À LA PRODUCTION DE COUCHES DE CARBONE DOPÉES

(30) Priorität: 19.03.2015 AT 702015 U
(43) Veröffentlichungstag der Anmeldung: 24.01.2018
(73) Patentinhaber: PLANSEE COMPOSITE MATERIALS GMBH, DE-86983 Lechbruck am See (DE)
(72) Erfinder: POLCIK, Peter, 6600 Reutte (AT); WÖRLE, Sabine, 6600 Pflach (AT); MILLER, Ulrich, 86956 Schongau (DE)
(74) Vertreter: Ciesla, Bettina
(86) Internationale Anmeldenummer: PCT/EP2016/000462
(87) Internationale Veröffentlichungsnummer: WO 2016/146256

(56) Entgegenhaltungen:
- JP-A- 2005 060 765
- US-A- 6 143 142
- US-A1- 2014 346 039
- L.J YU ET AL: "Etching behaviour of pure and metal containing amorphous carbon films prepared using filtered cathodic vacuum arc technique", APPLIED SURFACE SCIENCE, Bd. 195, Nr. 1-4, 1. Juli 2002 (2002-07-01), Seiten 107-116, XP055280277, AMSTERDAM, NL ISSN: 0169-4332, DOI: 10.1016/S0169-4332(02)00552-4

## Beschreibung

Die vorliegende Erfindung betrifft eine Beschichtungsquelle für die physikalische Dampfphasenabscheidung von dotierten Kohlenstoffschichten, insbesondere von dotierten amorphen Kohlenstoffschichten, und ein Herstellungsverfahren für eine derartige Beschichtungsquelle.

Amorphe Kohlenstoffschichten (engl. amorphous diamond-like carbon, DLC) sind kohlenstoffhaltige Schichten, die im Gegensatz zu Grafitschichten (besitzen kristalline Struktur und sp² hybridisierte Kohlenstoffatome) und Diamantschichten (haben kristalline Struktur und sp³ hybridisierte Kohlenstoffatome) strukturell aus einem amorphen Netzwerk von sp² und sp³ hybridisierten Kohlenstoffatomen bestehen. Amorphe Kohlenstoffschichten können wasserstofffrei oder wasserstoffhaltig sein und Dotierungen anderer Elemente enthalten. In VDI 2840 (Verein Deutscher Ingenieure, Kohlenstoffschichten, Grundlagen, Schichttypen und Eigenschaften) sind die verschiedenen Schichttypen amorpher Kohlenstoffschichten klassifiziert. Aufgrund sowohl grafit- als auch diamantähnlicher Strukturen liegen viele Eigenschaften von amorphen Kohlenstoffschichten zwischen denen von Grafit und Diamant. Amorphe Kohlenstoffschichten zeichnen sich durch eine diamantähnliche Härte (Härte bis zu 90 GPa) aus und haben zugleich hohe Verschleißbeständigkeit, einen geringen Reibkoeffizienten und eine gute Schichthaftung. Diese Schichten werden daher zunehmend unter anderem für tribologische Anwendungen, beispielsweise als reibungsmindernde und verschleißbeständige Beschichtungen bei Automobilkomponenten, eingesetzt. Zusätzlich weisen amorphe Kohlenstoffschichten eine ausgezeichnete biologische Verträglichkeit auf.

Neben diesen vorteilhaften Eigenschaften ist eine beschränkte thermische Stabilität nachteilig, denn die schlechte Oxidationsbeständigkeit von amorphen Kohlenstoffschichten führt zu einer begrenzten Einsatztemperatur von etwa 350°C.

Amorphe Kohlenstoffschichten werden in der Regel als Dünnschichten mit Schichtdicken von wenigen Mikrometern abgeschieden, üblicherweise über chemische oder physikalische Gasphasenabscheidung. Als wichtiges chemisches Gasphasenabscheidungsverfahren (engl. chemical vapour deposition, CVD) ist dabei die plasmaunterstützte chemische Gasphasenabscheidung (engl. plasma-assisted CVD (PA-CVD), auch als plasma-enabled CVD bezeichnet) zu nennen, bei der die chemische Abscheidung durch ein Plasma, üblicherweise durch eine äußere Hochfrequenz-Wechselspannung erzeugt, unterstützt wird. Die zur Herstellung von amorphen Kohlenstoffschichten gebräuchlichsten physikalischen Gasphasenabscheidungsverfahren (engl. physical vapour deposition, PVD) sind Magnetron-Kathodenzerstäubung (engl. magnetron sputter deposition) und Lichtbogenverdampfen (engl. arc-PVD, auch arc evaporation). Bei der Magnetron-Kathodenzerstäubung wird in einer Kammer ein durch ein Plasma ionisiertes Arbeitsgas (z.B. Argon oder kohlenstoffhaltige Gase) auf ein aus dem Beschichtungsmaterial gebildetes Target beschleunigt, wodurch Teilchen des Beschichtungsmaterials herausgeschlagen werden, in die Gasphase übertreten und aus der Gasphase auf dem zu beschichtenden Substrat abgeschieden werden. In der Nähe der aktiven Oberfläche des Targets ist ein zusätzliches Magnetfeld angelegt, um die Sputterrate zu erhöhen und somit den Beschichtungsvorgang zu beschleunigen. Beim Verfahren der Lichtbogenverdampfung wird das als Kathode bereitgestellte Beschichtungsmaterial durch einen über die Kathode wandernden Lichtbogen lokal geschmolzen und verdampft. Der teilweise ionisierte Beschichtungsmaterialdampf breitet sich, gegebenenfalls unterstützt durch eine zusätzlich angelegte elektrische Spannung, von der Kathode aus und kondensiert an der zu beschichtenden Substratoberfläche. Die Herstellung amorpher Kohlenstoffschichten mittels Lichtbogenverdampfung von Grafitkathoden ist aufgrund der starken Temperaturabhängigkeit der elektrischen Leitfähigkeit von Grafit sehr schwierig. Durch die geringe Beweglichkeit des Lichtbogens kommt es häufig zu sogenannten Pinning-Effekten, bei denen der Lichtbogen lokal an einer Stelle hängen bleibt, wodurch ein homogener Abtrag der Grafitkathoden behindert wird.

Ein Vorteil von PVD Verfahren gegenüber CVD Verfahren ist, dass im Allgemeinen die thermische Belastung des Substrates bei PVD Verfahren geringer ist als bei CVD Verfahren und daher mittels PVD Verfahren auch temperatursensiblere Materialien beschichtet werden können. Bei Einsatz eines Reaktivgases kann es auch bei PVD Verfahren zu chemischen Reaktionen mit dem Arbeitsgas kommen.

Die Eigenschaften amorpher Kohlenstoffschichten sind vielfältig und können durch Variation des Wasserstoffgehalts und geeigneter Dotierungen in weiten Bereichen eingestellt werden. Generell kommen als Dotierungsmaterial (Dotand) sowohl Metalle (karbidbildende Metalle wie beispielsweise Wolfram, Titan oder Vanadium und nicht karbidbildende Metalle wie Gold, Kupfer oder Silber) als auch nichtmetallische Elemente (beispielsweise Silizium, Sauerstoff, Stickstoff, Fluor und Bor) zur Anwendung. So kann beispielsweise die thermische Stabilität, die Verschleißbeständigkeit und der Reibungskoeffizient der Kohlenstoffschichten durch Dotierung mit Silizium, Titan, Chrom, Wolfram oder Molybdän beeinflusst werden, wobei der Anteil des Dotanden üblicherweise kleiner als 25 mol% (Molprozent) ist.

Die Herstellung qualitativ hochwertiger dotierter amorpher Kohlenstoffschichten ist derzeit mit zahlreichen Herausforderungen verbunden. Einerseits wird die Komplexität des Beschichtungsprozesses signifikant erhöht. Bei CVD Verfahren erfolgt die Dotierung durch zusätzliches Verdampfen einer chemischen Verbindung des gewünschten Dotanden (für eine Titan-dotierte amorphe Kohlenstoffschicht beispielsweise durch Verdampfen von TiCl₄), bei PVD Verfahren durch paralleles Zerstäuben (Co-sputtern) von Grafit und eines elementaren Targets bzw. Kathode (beispielsweise einer zusätzlichen Titanbeschichtungsquelle). Besonders nachteilig bei der Verwendung mehrerer Beschichtungsquellen ist die schlechte Homogenität der aufgebrachten Schichten, zudem sind in der Regel niedrigere Wachstumsraten zu erzielen. Bei der Herstellung dotierter Kohlenstoffschichten haben CVD Verfahren gegenüber PVD Verfahren den Nachteil, dass viele wichtige Dotanden wie beispielsweise Molybdän oder Wolfram nicht in einer geeigneten flüssigen bzw. gasförmigen Verbindung vorliegen. Dies ist einer der Nachteile gegenüber den PVD Verfahren.

Zur Verbesserung der Schichthomogenität gibt es erste Ansätze, bei denen die benötigten Beschichtungsmaterialien in einem Target bzw. einer Kathode aus einem Werkstoffverbund zusammengefügt werden (Chaus et al., Surface, microstructure and optical properties of copper-doped diamond-like carbon coating deposited in pulsed cathodic arc plasma, Diamond & Related Materials 42 (2014), p 64-70). In Chaus et al. wird ein zylindrisches Kathodentarget aus Grafit (Durchmesser 32 mm) verwendet, in das Stäbe aus dem Dotanden Kupfer (Durchmesser 6 mm) eingebettet sind (sogenannte Stopfenkathode). Die Qualität der erzeugten Schichten ist allerdings für industrielle Anwendungen nicht völlig zufriedenstellend, da nichtsdestotrotz Inhomogenitäten in der Beschichtungsschicht auftreten, die auf die zeitlich variierende Zusammensetzung des verdampften Beschichtungsmaterials zurückzuführen sind. Zudem ist aufgrund unterschiedlicher Verdampfungsraten zwischen dem Grafitbereich und dem Kupferstäben die Abtragung der Kathode inhomogen und die Lebensdauer der Kathode vermindert.

Es sind ferner Targets bekannt, bei denen ein poröser Grundkörper aus Grafit mit einer Schmelze aus einem Dotanden oder über eine Gasphase, die den Dotanden beinhaltet, infiltriert wird. Zwecks Infiltrierbarkeit muss der Grafit-Grundkörper eine offenporige Struktur haben und aus diesem Grund kann bei infiltrierten Grafit-Targets der Anteil des Dotanden nicht unterhalb eines bestimmten Schwellwerts gewählt werden. Wird die Infiltration vorzeitig beendet, um niedrige Gehalte an Dotanden einzustellen, so bleibt ein hoher Anteil an Porosität übrig. Nachteilig ist zudem, dass beim Beschichtungsprozess aufgrund des zusammenhängenden Netzwerks des Dotanden im Target Inhomogenitäten beim Materialabtrag auftreten.

Ein Beispiel für eine Beschichtungsquelle, bei der Grafit und Dotand in einer Einheit zusammengeführt sind, wird in JP2005/060765 angedeutet. Genauere Ausführungen über den Aufbau der Beschichtungsquelle sowie das Herstellungsverfahren, ob beispielsweise in Form einer Stopfenkathode oder in Form eines infiltrierten Targets, fehlen.

Des Weiteren beschreibt die US 6,143,142 A die Herstellung von Beschichtungen aus Kohlenstoff und einem anderen Element und die Verwendung von Targets aus Kohlenstoff und Silizium, sowie Kohlenstoff und Aluminium. L. J. Yu et al. (Applied Surface Science 195 (2002) 107-116) beschreibt die Verwendung von ungesinterten Kathoden aus reinem Grafit oder aus AI-Ti-Grafit Kathoden. Die US 2014/0346039 A1 beschreibt Targets mit im Target verteilten Kohlenstoff Partikeln für die Herstellung von magnetischen Aufnahmemedien.

Aufgabe der vorliegenden Erfindung ist, eine Beschichtungsquelle für die physikalische Dampfphasenabscheidung zur Herstellung von dotierten Kohlenstoffschichten, insbesondere von dotierten amorphen Kohlenstoffschichten zur Verfügung zu stellen, bei denen die bei der Verwendung von mehreren Beschichtungsquellen auftretenden vorhin genannten Nachteile vermieden bzw. reduziert werden. Die Beschichtungsquelle soll insbesondere eine möglichst homogene Verteilung des Dotanden in der abgeschiedenen Kohlenstoffschicht ermöglichen. Zudem soll sie bei einer Lichtbogenverdampfung zu keiner örtlich erhöhten Verdampfungsrate neigen. Weiters ist Aufgabe der vorliegenden Erfindung, ein Herstellungsverfahren für eine derartige Beschichtungsquelle zu schaffen.

Diese Aufgabe wird durch ein Verfahren zur Herstellung einer Beschichtungsquelle für die Dampfphasenabscheidung von dotierten Kohlenstoffschichten gemäß Anspruch 1 und durch eine dotierte Beschichtungsquelle gemäß Anspruch 6 gelöst. Vorteilhafte Ausgestaltungen der Erfindung sind Gegenstand von abhängigen Unteransprüchen.

Die erfindungsgemäße dotierte Beschichtungsquelle wird durch Sintern einer Pulvermischung aus kohlenstoffhaltigem Pulver (bzw. einer kohlenstoffhaltigen Pulvermischung) und Dotand-haltigem Pulver (bzw. einer Dotand-haltigen Pulvermischung) hergestellt. Sie weist Kohlenstoff als Matrixmaterial mit einem Stoffmengenanteil von mindestens 75 mol% und mindestens einen Dotanden mit einem Stoffmengenanteil zwischen 1 mol% und 25 mol%, bevorzugt zwischen 1 mol% und 20 mol%, besonders bevorzugt zwischen 2 mol% und 10 mol% auf. Vorteilhafterweise kann dabei der Stoffmengenanteil des mindestens einen Dotanden kleiner 5 mol% sein. Neben dem Dotand können in der Beschichtungsquelle übliche herstellungsbedingte Verunreinigungen wie beispielsweise Schwefel vorhanden sein, wobei die Menge an Verunreinigungen typischerweise geringer als 1000 ppm ist. Der Dotand dient der gezielten Modifikation der unter Verwendung der Beschichtungsquelle abgeschiedenen Kohlenstoffschicht.

Der Dotand kann ein Metall oder ein Halbmetall sein. Der Dotand kann auch eine oxidische, nitridische, boridische oder silizidische Verbindung eines Metalls oder eines Halbmetalls sein. Insbesondere können als Dotand die Metalle Titan, Vanadium, Chrom, Zirkon, Niob, Molybdän, Hafnium, Tantal, Wolfram und das Halbmetall Silizium verwendet werden. Als Dotand können zudem Oxide, Nitride, Boride oder Silizide der Metalle Titan, Vanadium, Chrom, Zirkon, Niob, Molybdän, Hafnium, Tantal, Wolfram oder Oxide, Nitride, Boride des Halbmetalls Silizium verwendet werden.

Der Dotand kann in der Beschichtungsquelle in im Wesentlichen unveränderter Form vorliegen oder mit dem Matrixmaterial Kohlenstoff während des Sintervorganges chemisch reagiert haben. Der Dotand kann auch in Form einer karbidischen Verbindung des Dotanden in das Matrixmaterial eingebracht worden sein, beispielsweise als Metallkarbid oder Halbmetallkarbid.

Mit dem Dotanden wird in der vorliegenden Anmeldung auf ein oder mehrere Elemente oder chemische Verbindungen Bezug genommen, die, abgesehen von etwaigen Verunreinigungen, in der Beschichtungsquelle neben dem Kohlenstoff vorliegen. Wird die Beschichtungsquelle unter Verwendung eines Pulvers aus einer karbidischen Verbindung eines Dotiermaterials hergestellt oder kommt es während des Sintervorgangs zu chemischen Reaktionen zwischen dem Dotiermaterial mit dem Kohlenstoff, so wird in der vorliegenden Erfindung mit dem Dotanden also auf das Dotiermaterial Bezug genommen und nicht auf die karbidische Verbindung des Dotiermaterials. Wird beispielsweise die Beschichtungsquelle aus einem Ausgangspulver aus einem Metallkarbid bzw. einem Halbmetallkarbid hergestellt, so wird in der vorliegenden Erfindung als Dotand der Beschichtungsquelle das entsprechende Metall bzw. Halbmetall verstanden und nicht das Metallkarbid bzw. Halbmetallkarbid. Analoges gilt bei Verwendung eines Metall- bzw. Halbmetallpulvers, das beim Herstellungsprozess mit dem Kohlenstoff reagiert. Auch hier wird in der vorliegenden Erfindung als Dotand das entsprechende Metall bzw. Halbmetall verstanden und nicht die karbidische Verbindung des Metalls bzw. Halbmetalls. Beide Beschichtungsquellen führen beim Beschichtungsprozess zu einer mit dem entsprechenden Metall bzw. Halbmetall dotierten Kohlenstoffschicht.

Die Dotierung in der Beschichtungsquelle kann, muss aber nicht zwangsläufig mit der Dotierung in der mittels der Beschichtungsquelle abgeschiedenen Kohlenstoffschicht übereinstimmen. Aufgrund von verschiedenen Vorgängen beim Beschichtungsprozess, beispielsweise chemischen Reaktionen mit dem Prozessgas, kann sich die chemische Zusammensetzung der abgeschiedenen dotierten Kohlenstoffschicht bzw. das Verhältnis zwischen Dotiermaterial und Kohlenstoff in der abgeschiedenen Kohlenstoffschicht von der Dotierung in der Beschichtungsquelle unterscheiden.

Mit Beschichtungsquelle wird insbesondere auf ein Target bei der Magnetron-Kathodenzerstäubung bzw. auf eine Kathode bei der Lichtbogenverdampfung Bezug genommen.

Erfindungsgemäß ist der Dotand in Partikelform in eine Kohlenstoffmatrix fein verteilt eingebettet. Dies wird durch die Herstellung der Beschichtungsquelle mittels Sintern aus pulverförmigen Komponenten erreicht. Kohlenstoff (Grafit) und Dotand liegen daher nicht wie beim Stand der Technik in separaten Beschichtungsquellen oder in einer Beschichtungsquelle in makroskopisch voneinander getrennten Bereichen, wie beispielsweise bei Stopfenkathoden oder bei durch Infiltrieren hergestellten Beschichtungsquellen, vor. Die erfindungsgemäße dotierte Beschichtungsquelle vereinfacht die Herstellung und erhöht die Qualität der damit abgeschiedenen dotierten Kohlenstoffschichten signifikant. Während bei herkömmlichen Beschichtungsquellen (getrenntes Grafit und Dotandtarget bzw. -kathode) die Betriebsparameter jeder einzelnen Beschichtungsquelle separat überwacht werden müssen, um näherungsweise homogen dotierte Schichten zu erzielen, wird bei der vorliegenden Erfindung Kohlenstoff und Dotand aus derselben Beschichtungsquelle verdampft bzw. zerstäubt. Es sind daher nur noch die Betriebsparameter für eine einzelne Beschichtungsquelle zu regeln. Das Verhältnis der Verdampfungsrate zwischen Matrixmaterial und Dotand ist weitgehend zeitunabhängig. Die Zusammensetzung des verdampften Materials ist zudem auch weitgehend ortsunabhängig und variiert örtlich kaum über die zu beschichtende Substratoberfläche. Es können daher die beim Stand der Technik vor allem bei der Beschichtung von großflächigen Substraten auftretenden Probleme vermieden werden, bei denen die Beschichtungsquellen aus Grafit und Dotand an verschiedenen Orten positioniert sind und sich die aus den einzelnen Beschichtungsquellen stammenden Elemente auf der zu beschichtenden Substratfläche nicht gleichmäßig abscheiden.

Ein weiterer Vorteil ist, dass bei Lichtbogenverdampfung der Abtrag der als Kathode ausgebildeten Beschichtungsquelle gleichmäßiger verläuft. Die Dotand-haltigen Partikel wirken als Störelemente im Gefüge der Kathode und beeinflussen positiv die Laufeigenschaften des Lichtbogens über die Oberfläche der Kathode. Der Lichtbogen wird dadurch immer wieder unterbrochen und an anderer Stelle neu gezündet. Durch die besseren Laufeigenschaften des Lichtbogens wird auch die Qualität der abgeschiedenen Schichten verbessert. Bei der erfindungsgemäßen Kathode kommt es seltener zu Pinning-Effekten und dadurch weniger stark ausgeprägten lokalen Aufschmelzungen als bei einer reinen Grafitkathode, Abscheidungen in Form von Spritzern (Droplets) treten daher vermindert auf.

Das Gefüge der Beschichtungsquelle weist erfindungsgemäß zumindest zwei unterschiedliche kristallografische Phasen auf, wobei zumindest eine Phase den Dotanden aufweist. Die Dotand-haltigen Partikel können also eine eigene kristallografische Phase in der Phase des Matrixmaterials Kohlenstoff ausbilden. Der Dotand kann mit dem Kohlenstoff chemisch reagieren oder in mit dem Kohlenstoff nicht reagierter Form vorliegen. In der vorliegenden Erfindung wird unter Dotand-haltigem Partikel sowohl ein Partikel, bei dem der Dotand in mit dem Kohlenstoff abreagierter Form vorliegt, als auch ein Partikel, bei dem der Dotand in mit dem Kohlenstoff nicht abreagierter Form vorliegt, verstanden.

In einer bevorzugten Ausführungsform ist die mittlere Korngröße der Dotand-haltigen Partikel kleiner als 50µm, insbesondere kleiner als 20µm. Die Dotand-haltigen Partikel sind makroskopisch (auf einer Längenskala im mm-Bereich) gleichmäßig im Gefüge der Beschichtungsquelle verteilt. Bevorzugt ist der mittlere Abstand der Dotand-haltigen Partikel kleiner als 50µm, insbesondere kleiner als 20µm. Die geringe Größe und feinen Verteilung des Dotanden in der Kohlenstoffmatrix bewirkt eine äußerst homogene und zeitlich konstante Zusammensetzung des verdampften bzw. zerstäubten Beschichtungsmaterials, es gelingt dadurch, Kohlenstoffschichten mit sehr gleichmäßig verteiltem Dotanden abzuscheiden.

Die Verteilung der Dotand-haltigen Partikel, die mittlere Korngröße und der mittlere Abstand wird - wie in dem Fachgebiet bekannt - anhand eines Querschnitts der Probe ermittelt. Die erhaltene Oberfläche wird dabei in ein Harz eingebettet, geschliffen, poliert und mit einem Rasterelektronenmikroskop (oder alternativ mit einem Lichtmikroskop) untersucht und quantitativ ausgewertet. Unter gleichmäßiger Verteilung der Dotand-haltigen Partikel ist zu verstehen: Betrachtet man einen Querschnitt der Probe unter einem Rasterelektronenmikroskop und wertet die Anzahl der Dotand-haltigen Partikel in verschiedenen, repräsentativen Bildausschnitten aus, so ist die Streuung der Häufigkeitsverteilung der Anzahl der Dotand-haltigen Partikel pro Bildausschnitte gering. Wählt man beispielsweise für die Größe des Bildausschnitts ein Quadrat mit einer Länge von etwa dem 25-fachen der mittleren Partikelgröße der Dotand-haltigen Partikel und ermittelt in einer Serie von 10 verschiedenen Bildausschnitten jeweils pro Bildausschnitt die Anzahl der Dotand-haltigen Partikel, die sich vollständig innerhalb des Bildausschnitts befinden, so weicht bei den einzelnen Bildausschnitten die Anzahl der Dotand-haltigen Partikel nicht mehr als um einen Faktor 3 von der (aus den 10 Bildausschnitten ermittelten) durchschnittlichen Anzahl von Dotand-haltigen Partikel pro Bildausschnitt ab.

Die erfindungsgemäße Beschichtungsquelle wird in Form eines Targets oder als Kathode zur physikalischen Dampfphasenabscheidung von dotierten Kohlenstoffschichten, insbesondere von dotierten amorphen Kohlenstoffschichten, verwendet. Beim Beschichtungsprozess kommen bevorzugt kohlenstoffhaltige Prozessgase wie Acetylen oder Methan zum Einsatz.

Die Erfindung betrifft auch ein Herstellungsverfahren der oben beschriebenen Beschichtungsquelle. Zur Herstellung einer derartigen Beschichtungsquelle wird von einer Pulvermischung aus kohlenstoffhaltigem Pulver und Pulver, das den gewünschten Dotanden aufweist, ausgegangen. Als kohlenstoffhaltiges Pulver können Pulver oder eine Pulvermischung aus natürlichem oder synthetischen Grafit, Koks, amorphen Kohlenstoff oder Ruß verwendet werden. Grafit, Koks und Ruß besitzen eine grafitische Kristallstruktur, Unterschiede bestehen in der Fehlerfreiheit und Größe der einzelnen Kristallite. Unter dem Dotand-haltigen Pulver wird auch eine Pulvermischung, die den Dotanden aufweist, verstanden sowie insbesondere auch ein Pulver bzw. eine Pulvermischung aus einer karbidischen Verbindung des Dotanden. Zur Herstellung einer Beschichtungsquelle für die Abscheidung einer mit einem Metall oder Halbmetall dotierten Kohlenstoffschicht kann ein Pulver des entsprechenden Metalls bzw. Halbmetalls verwendet werden. Es kann aber auch ein Pulver eines Karbids des entsprechenden Metalls oder Halbmetalls verwendet werden. Eine aus einem derartigen Karbidpulver hergestellte Beschichtungsquelle führt beim Beschichtungsprozess auch zu einer mit dem entsprechenden Metall bzw. Halbmetall dotierten Kohlenstoffschicht. Sollte eine Beschichtungsquelle zur Abscheidung von Kohlenstoffschichten mit mehreren Dotanden benötigt werden, so kann die Pulvermischung Komponenten mehrerer Dotanden aufweisen.

Die Ausgangspulver können trocken oder nass gemahlen werden und werden in einer Mischkammer intensiv vermischt. Der Mahlvorgang kann unter Beigabe von Mahlkugeln erfolgen, wodurch Agglomerate und Klumpen aus Partikeln zerkleinert werden, eine homogene Verteilung der Mischkomponenten erzielt wird und der Mischvorgang beschleunigt wird. Die erhaltene Pulvermischung weist bevorzugt eine mittlere Partikelgröße mit einem Durchmesser kleiner als 50 µm auf. Bevorzugt weist das kohlenstoffhaltige Pulver und/oder das Dotand-haltige Pulver eine mittlere Partikelgröße mit einem Durchmesser kleiner als 50 µm auf, wodurch eine äußerst homogene Verteilung des Dotanden in der Beschichtungsquelle erzielt werden kann. Es wird ein geeignetes Mischverhältnis zwischen Dotand und kohlenstoffhaltigem Pulver eingestellt, sodass nach dem Sinterprozess ein Formkörper mit einem Kohlenstoffanteil von mindestens 75 mol% und mindestens einem Dotanden mit einem Anteil zwischen 1 mol% und 25 mol%, insbesondere zwischen 1 mol% und 20 mol%, erhalten wird.

Nach dem Mahlprozess wird die Pulvermischung in ein Formwerkzeug, beispielsweise in eine Grafitform, eingefüllt und bei Temperaturen von 1300°C bis 3000°C, in geeigneter Atmosphäre gesintert. Der Sinterprozess erfolgt insbesondere in inerter oder reduzierender Atmosphäre oder im Vakuum. Der Sinterprozess erfolgt erfindungsgemäß druckunterstützt, d.h. das Sintern erfolgt unter Verdichten der Pulvermischung bei einem angelegten mechanischen Druck von 5 bis 50 MPa. Der mechanische Druck wird vorteilhafterweise beim Aufheizen stufenweise aufgebracht und eine gewisse Zeit aufrechterhalten. Erfindungsgemäße Sinterverfahren für die Beschichtungsquelle sind rasche Heißpressverfahren, beispielsweise über Heizleiter beheiztes Heißpressen oder induktiv beheiztes Heißpressen, oder Sinterverfahren mittels direkten Stromdurchgang (beispielsweise Spark Plasma Sintern). Während beim Sintern im direktem Stromdurchgang die Wärme intern durch einen durch das Pulver geführten Stromfluss erzeugt wird, wird beim Heißpressen die Wärme von außerhalb zugeführt. Diese Verfahren zeichnen sich durch hohe Heiz- und Abkühlraten und kurze Prozesszeiten aus. Erfindungsgemäß weisen die so hergestellten Formkörper eine hohe Dichte mit mindestens 80%, bevorzugt mit mindestens 90% der theoretischen Dichte auf. Wird die Pulvermischung beim Sintervorgang in uniaxialer Richtung gepresst, so entsteht ein Formkörper, bei dem das Gefüge eine gerichtete Struktur aufweist, die in eine Richtung normal zur Pressrichtung ausgerichtet ist, das Gefüge weist also eine bevorzugte Ausrichtung auf. Optional kann der gesinterte Formkörper nach dem Sintern zur Grafitierung bei Temperaturen im Bereich von 2000°C bis 3000°C ohne zusätzlich angelegten äußeren Druck wärmebehandelt werden. Durch diese Hochtemperaturbehandlung wird bewirkt, dass die Größe und der Anteil der Grafitkristallite zunehmen, außerdem wird die thermische und elektrische Leitfähigkeit des Formkörpers verbessert. Gleichzeitig wird der Formkörper reiner, da (abgesehen von den gewünschten Dotanden) eventuelle Verunreinigungen verdampfen.

Abschließend wird der gesinterte Formkörper mechanisch, beispielsweise durch spanabhebende Werkzeuge, zur gewünschten Endform der Beschichtungsquelle verarbeitet.

Die Herstellung der erfindungsgemäßen dotierten Grafit-Beschichtungsquelle hat gegenüber der Herstellung einer reinen Grafit-Beschichtungsquelle einen wichtigen Vorteil. Reiner Kohlenstoff (Grafit) ist schwer sinterbar, da für den Zusammenhalt des Kohlenstoffpulvers eine zusätzliche Bindemittelmatrix erforderlich ist. Üblicherweise kommen hierfür Peche oder Polymere mit hohem Kohlenstoffgehalt zum Einsatz, die in einem thermischen Behandlungsschritt in Kohlenstoff umgesetzt werden. Bei der Herstellung einer dotierten Kohlenstoff-Beschichtungsquelle wird durch die Zugabe des Dotanden der Sintervorgang unterstützt, teilweise durch die Reaktion der Dotanden mit dem Kohlenstoff. Es wird zudem eine bessere Verdichtung des Formkörpers erreicht.

Im Folgenden wird die Erfindung anhand von drei Ausführungsbeispielen und dazugehörigen Abbildungen näher erläutert. Ausführungsbeispiel 1 betrifft Varianten von mit dem Halbmetall Silizium dotierten Beschichtungsquellen, Ausführungsbeispiel 2 eine mit dem Metall Titan dotierte Beschichtungsquelle, und Ausführungsbeispiel 3 betrifft eine mit der chemischen Verbindung Chromdiborid dotierte Beschichtungsquelle.

Ausführungsbeispiel 1:
Als Ausführungsbeispiel 1 wurde ein rondenförmiges Target mit 75 mm Durchmesser und 5 mm Dicke aus einer Pulvermischung aus Grafit (C) und Silizium (Si) hergestellt. Als Ausgangsmaterial wurden ca. 1,5 kg einer Mischung aus Si Pulver und C Pulver (mittlere Korngröße d 50 von etwa 10 µm) im Mischverhältnis von 10/90 mol% verwendet, die unter Zugabe von 5 I Isopropanol und 5 kg Mahlkugeln aus Si-Nitrid 4 Stunden lang in einem Topfroller nass gemahlen wurden. Nach Abtrennung der Mahlkugeln wurde der Pulveransatz durch Verdampfen des Alkohols bei ca. 100°C getrocknet und anschließend in einer Siebanlage mit einer Maschenweite von 1 mm fraktioniert. Die chemische Analyse des dadurch entstandenen Si/C Pulveransatzes ergab einen Si-Anteil von 10 mol % und einen Kohlenstoffgehalt von 90 mol%. Die Pulvermischung wurde anschließend in einer Spark-Plasma-Sinter-Anlage (SPS Anlage) unter Verwendung von Grafit-Presswerkzeugen bei einem Pressdruck von 30 MPa verdichtet und bei einer Temperatur von 2100°C zu einer Ronde mit 85 mm Durchmesser und 8 mm Dicke in direktem Stromdurchgang gesintert. Es wurde dabei bei einer Sintertemperatur von 2100°C eine Dichte von 1,90 g/cm³ erzielt, was 88 % der theoretischen Dichte des Materials entspricht. Die gesinterte Ronde wurde durch Zerspanung zu einem Target mit 75 mm Durchmesser und 5 mm Dicke endbearbeitet.

Es wurden zusätzliche Varianten (Mischverhältnis von C zu Si- Pulver: 90/10 mol%) bei den Sintertemperaturen 1500°C und 1800°C hergestellt, bei denen eine Dichte von 1,77 g/cm³ (83 % der theoretischen Dichte) (bei 1500°C) bzw. eine Dichte von 1,78 g/cm³ (83% der theoretischen Dichte) (bei 1800°C) erzielt wurde.

Zur Analyse der gesinterten Ronde wurden aus der Ronde Proben ausgeschnitten und im Querschliff mittels Rasterelektronenmikroskopie und röntgenographischer Phasenanalyse analysiert.

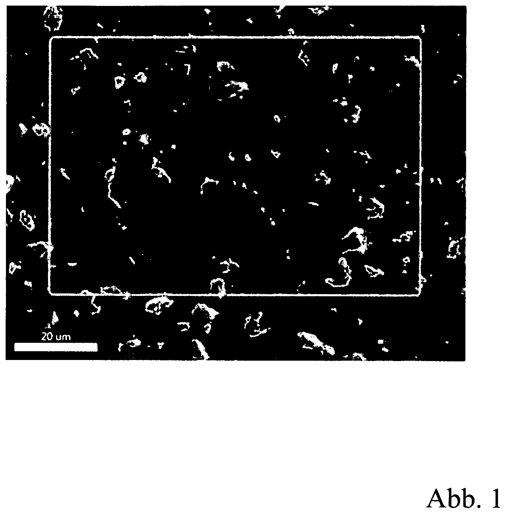

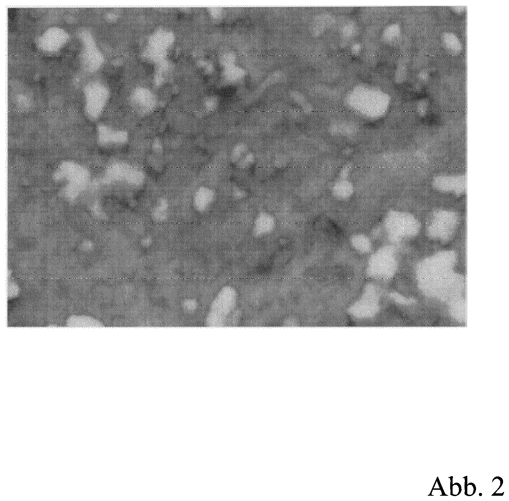

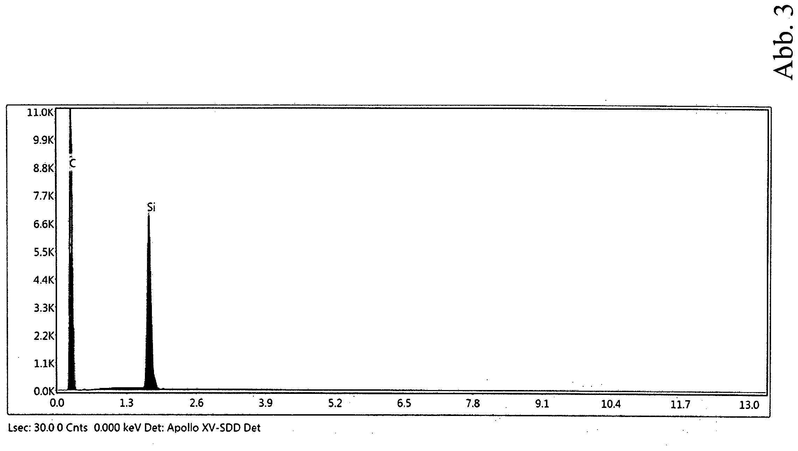

In Abbildung 1 ist eine rasterelektronenmikroskopische Aufnahme des Gefüges eines Querschliffs durch die bei 2100°C gesinterte Rondenprobe dargestellt (die Größe des Bildausschnitts beträgt etwa 115 µm mal 90 µm, der Maßstabsbalken entspricht 20 µm). In der Aufnahme zeigt sich eine feinkörnige, homogene Struktur des Gefüges. Darüber hinaus ist die hohe Dichte des Gefüges mit einer sehr geringen Porosität zu sehen. In dieser Abbildung ist die gerichtete Struktur des Gefüges nicht erkennbar, da die Ebene des Querschliffs senkrecht zur Pressrichtung und damit auch auf die Ausrichtung des Gefüges. Abbildung 2 zeigt die mittels energiedispersiver Röntgenspektroskopie (EDX) ermittelte Elementverteilung des in Abbildung 1 umrahmten Bereichs der Probe, wobei Si hell und C dunkel dargestellt ist. Aus der EDX Analyse (in Abbildung 3 ist die Anzahl der Zählimpulse als Funktion der Energie in keV dargestellt) ergibt sich, dass die Ronde im Wesentlichen nur aus den Elementen Si und C besteht. Die Messung der Korngröße ergab für die Si-haltigen Partikel einen mittleren Durchmesser kleiner als 10 µm, der mittlere Abstand dieser Partikel ist kleiner als 20 µm. Die Si-haltigen Partikel sind im Gefüge der Beschichtungsquelle gleichmäßig verteilt.

Ein Röntgen-Diffraktogramm (XRD) der Probe zeigt, dass der Dotand Silizium nur in Form von Si-Karbid vorliegt, also in mit dem Kohlenstoff abreagierter Form, was auf eine während des Sintervorgangs abgelaufene chemische Reaktion zwischen Silizium und Kohlenstoff hinweist. Es liegen im Gefüge also zwei unterschiedliche kristallographische Phasen, eine C-Phase und eine Si-Karbid-Phase, vor.

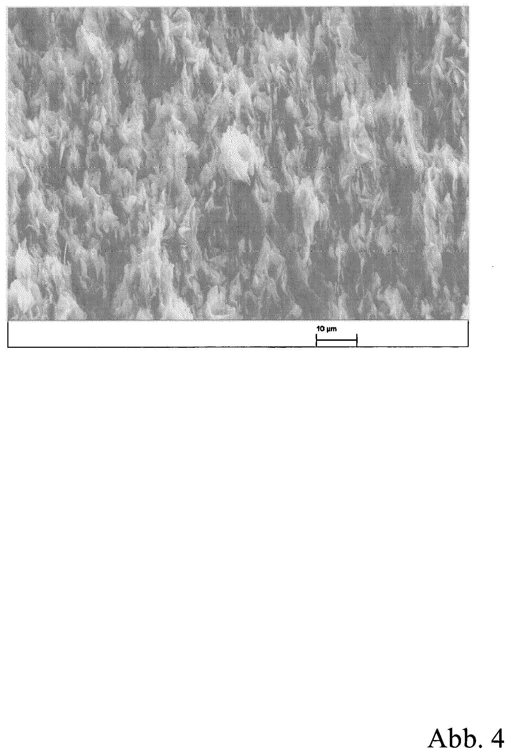

Abbildung 4 zeigt eine rasterelektronenmikroskopische Aufnahme des Gefüges eines Querschliffs einer Variante eines mit Silizium dotierten Targets mit einem Si-Anteil von 5 mol% und einem Kohlenstoffgehalt von 95 mol%. Das Target wurde analog zu den obigen Varianten mit entsprechendem Mischverhältnis C/Si-Pulver in einer SPS-Anlage bei einer Sintertemperatur von 1500°C hergestellt (der Maßstabsbalken entspricht 10 µm). Im Gefüge ist deutlich eine gerichtete Struktur erkennbar, die auf den Pressvorgang im Sintervorgang zurückzuführen ist.

Diese Varianten von mit Silizium dotierten Targets dienen zur Abscheidung von mit Silizium dotierten Kohlenstoffschichten, insbesondere von mit Silizium dotierten amorphen Kohlenstoffschichten. Die Abscheidung der gewünschten Schichten wurde anhand des zuerst beschriebenen Targetvariante demonstriert. Die bei 2100°C gesinterte Ronde aus dem Werkstoff CSi 90/10 mol% (Durchmesser 75 mm, Dicke 5 mm) wurde mittels Indium auf eine Rückplatte aus Kupfer mit einem Durchmesser von 75 mm und einer Stärke von 3 mm flächig gelötet. Das so erhaltene Target wurde in einer PVD Anlage im DC Sputterprozess zur Beschichtung eines Substrats aus Hartmetall eingesetzt. Das Target zeigte dabei ein stabiles Verhalten in Bezug auf die Zündung und die Stabilität des Plasmas bei Leistungen von 200 Watt (500 V und 0,4 A), 300 Watt (550 V und 0,55 A) und 400 Watt (570 V und 0,7 A). In den auf dem Substrat aus Hartmetall abgeschiedenen Schichten wurde Silizium und Kohlenstoff detektiert.

Ausführungsbeispiel 2:
Im Ausführungsbeispiel 2 wurde eine mit Titan dotierte Beschichtungsquelle zur Abscheidung von mit Titan dotierten Kohlenstoffschichten hergestellt. Als Ausgangsmaterial für das rondenförmige Target mit 75 mm Durchmesser und 5 mm Dicke wurden ca. 1,5 kg einer Mischung aus Ti Pulver und C Pulver (mittlere Korngröße d 50 von etwa 10 µm) im Mischverhältnis von 10/90 mol% verwendet, die unter Zugabe von 5 l Isopropanol und 5 kg Mahlkugeln aus Si-Nitrid 4 Stunden lang in einem Topfroller nass gemahlen wurden. Die einzelnen Fertigungsschritte sind analog zu den Verfahrensschritten beim Ausführungsbeispiel 1, die getrocknete Pulvermischung wurde bei einem Pressdruck von 30 MPa und einer Temperatur von 2100°C in direktem Stromdurchgang gesintert und anschließend mechanisch bearbeitet. Die an Querschnitten der gesinterten Probe durchgeführte XRD Untersuchung zeigte, dass Titan im Gefüge durch eine Reaktion mit dem Kohlenstoff nur in der Form von Ti-Karbid vorliegt.

Ausführungsbeispiel 3:
Beim Ausführungsbeispiel 3 wurde ein Target für die physikalische Dampfphasenabscheidung von mit Chrom-Diborid dotierten Kohlenstoffschichten hergestellt. Die Herstellschritte sind analog zu den in den Verfahrensschritten bei den vorherigen Ausführungsbeispielen. Als Ausgangsmaterial für das rondenförmige Target mit 75 mm Durchmesser und 5 mm Dicke wurden ca. 1,5 kg einer Mischung aus Chrom-Diborid Pulver und C Pulver (mittlere Korngröße d 50 von etwa 10 µm) im Mischverhältnis von 10/90 mol% verwendet, die unter Zugabe von 5 l Isopropanol und 5 kg Mahlkugeln aus Si-Nitrid 4 Stunden lang in einem Topfroller nass gemahlen wurden. Die getrocknete Pulvermischung wurde bei einem Pressdruck von 30 MPa und einer Temperatur von 2100°C zu einer Ronde mit 85 mm Durchmesser und 8 mm Dicke gesintert und anschließend mechanisch nachbearbeitet. Eine an Querschnitten der gesinterten Probe durchgeführte XRD Untersuchung zeigte, dass der Dotand in mit dem Kohlenstoff nicht abreagierter Form vorliegt.

## Patentansprüche

1. Verfahren zur Herstellung einer Beschichtungsquelle für die physikalische Dampfphasenabscheidung von dotierten Kohlenstoffschichten, wobei die Beschichtungsquelle Kohlenstoff als Matrixmaterial mit einem Anteil von mindestens 75 mol% und mindestens einen Dotanden mit einem Anteil zwischen 1 mol% und 25 mol% aufweist, wobei der Dotant in Partikelform in der Kohlenstoffmatrix feinverteilt eingebettet ist und das Gefüge der Beschichtungsquelle zumindest zwei unterschiedliche kristallographische Phasen aufweist und zumindest eine Phase den Dotanten aufweist, wobei die Beschichtungsquelle mindestens 80% theoretische Dichte aufweist, **dadurch gekennzeichnet, dass** dieses zumindest die folgenden Herstellschritte umfasst:
• Herstellen einer Pulvermischung aus kohlenstoffhaltigem Pulver und Dotand-haltigem Pulver
• Sintern der Pulvermischung mittels Sintern im direkten Stromdurchgang oder mittels Heißpressen bei Temperaturen von 1300°C bis 3000°C und einem Druck von 5MPa bis 50 MPa
• Mechanisches Bearbeiten des gesinterten Formkörpers zu einer Beschichtungsquelle

2. Verfahren nach Anspruch 1, **dadurch gekennzeichnet, dass** der Dotand ein Metall, ein Halbmetall, ein Metalloxid, ein Halbmetalloxid, ein Metallnitrid, ein Halbmetallnitrid, ein Metallborid, ein Halbmetallborid, ein Metallsilizid oder ein Halbmetallsilizid ist.

3. Verfahren nach Anspruch 1 oder 2, **dadurch gekennzeichnet, dass** der Dotand ein Element aus der Gruppe Titan, Vanadium, Chrom, Zirkon, Niob, Molybdän, Hafnium, Tantal, Wolfram, Silizium, eine oxidische, nitridische, boridische oder silizidische Verbindung eines Elements aus der Gruppe Titan, Vanadium, Chrom, Zirkon, Niob, Molybdän, Hafnium, Tantal, Wolfram oder eine oxidische, nitridische oder boridische Verbindung von Silizium ist.

4. Verfahren nach einem der vorangehenden Ansprüche, **dadurch gekennzeichnet, dass** das kohlenstoffhaltige Pulver und/oder das Dotand-haltige Pulver eine mittlere Partikelgröße mit einem Durchmesser kleiner als 50 µm aufweist.

5. Verfahren nach einem der vorangehenden Ansprüche, **dadurch gekennzeichnet, dass** der gesinterte Formkörper nach dem Sinterprozess zur Grafitierung ohne zusätzlichen angelegten Druck bei Temperaturen im Bereich von 2000°C bis 3000°C wärmebehandelt wird.

6. Beschichtungsquelle für die physikalische Dampfphasenabscheidung zur Herstellung von dotierten Kohlenstoffschichten, welche mittels Sintern aus pulverförmigen Komponenten hergestellt ist und Kohlenstoff als Matrixmaterial mit einem Anteil von mindestens 75 mol% und mindestens einen Dotanden mit einem Anteil zwischen 1 mol% und 25 mol% aufweist und der Dotant in Partikelform in der Kohlenstoffmatrix feinverteilt eingebettet ist und das Gefüge der Beschichtungsquelle zumindest zwei unterschiedliche kristallographische Phasen aufweist, wobei zumindest eine Phase den Dotanten aufweist und die Beschichtungsquelle eine Dichte von mindestens 80% theoretischer Dichte aufweist.

7. Beschichtungsquelle nach Anspruch 6, **dadurch gekennzeichnet, dass** der Dotand ein Metall, ein Halbmetall, ein Metalloxid, ein Halbmetalloxid, ein Metallnitrid, ein Halbmetallnitrid, ein Metallborid, ein Halbmetallborid, ein Metallsilizid oder ein Halbmetallsilizid ist.

8. Beschichtungsquelle nach Anspruch 6 oder 7, **dadurch gekennzeichnet, dass** der Dotand ein Element aus der Gruppe Titan, Vanadium, Chrom, Zirkon, Niob, Molybdän, Hafnium, Tantal, Wolfram, Silizium oder eine oxidische, nitridische, boridische oder silizidische Verbindung eines Elements aus der Gruppe Titan, Vanadium, Chrom, Zirkon, Niob, Molybdän, Hafnium, Tantal, Wolfram oder eine oxidische, nitridische oder boridische Verbindung von Silizium ist.

9. Beschichtungsquelle nach einem der Ansprüche 6 bis 8, **dadurch gekennzeichnet, dass** der mittlere Abstand der Dotand-haltigen Partikel kleiner als 50µm beträgt.

10. Beschichtungsquelle nach einem der Ansprüche 6 bis 9, **dadurch gekennzeichnet, dass** das Gefüge eine gerichtete Struktur aufweist.

11. Verwendung einer Beschichtungsquelle nach einem der Ansprüche 6 bis 10 zum Abscheiden von dotierten Kohlenstoffschichten.

## Claims

1. Process for producing a coating source for the physical vapour deposition of doped carbon layers, where the coating source comprises carbon as a matrix material in a proportion of at least 75 mol% and at least one dopant in a proportion in the range from 1 mol% to 25 mol%, wherein the dopant-containing particles are uniformly distributed in the microstructure of the carbon matrix and wherein the microstructure of the coating source has at least two different crystallographic phases and at least one phase comprising the dopant, wherein the coating source has a theoretical density of at least 80%,
**characterized in that** this process comprises at least the following production steps:
• production of a powder mixture composed of carbon-containing powder and dopant-containing powder
• sintering of the powder mixture by means of sintering with direct passage of current or by means of hot pressing at temperatures of from 1300°C to 3000°C and a pressure of 5 MPa to 50 MPa
• mechanical working of the sintered shaped body to give a coating source.

2. Process according to Claim 1, **characterized in that** the dopant is a metal, a semimetal, a metal oxide, a semimetal oxide, a metal nitride, a semimetal nitride, a metal boride, a semimetal boride, a metal silicide or a semimetal silicide.

3. Process according to Claim 1 or 2, **characterized in that** the dopant is an element from the group consisting of titanium, vanadium, chromium, zirconium, niobium, molybdenum, hafnium, tantalum, tungsten, silicon, an oxidic, nitridic, boridic or silicidic compound of an element from the group consisting of titanium, vanadium, chromium, zirconium, niobium, molybdenum, hafnium, tantalum, tungsten or an oxidic, nitridic or boridic compound of silicon.

4. Process according to any of the preceding claims, **characterized in that** the carbon-containing powder and/or the dopant-containing powder has an average particle size having a diameter of less than 50 µm.

5. Process according to any of the preceding claims, **characterized in that** the sintered shaped body is heat-treated without additional applied pressure at temperatures in the range from 2000°C to 3000°C after the sintering process in order to effect graphitization.

6. Coating source for the physical vapour deposition to produce doped carbon layers, which has been produced by means of sintering from pulverulent components and comprises carbon as matrix material in a proportion of at least 75 mol% and at least one dopant in a proportion in the range from 1 mol% to 25 mol%, wherein the dopant-containing particles are uniformly distributed in the microstructure of the carbon matrix and wherein the microstructure of the coating source has at least two different crystallographic phases, wherein at least one phase comprises the dopant and wherein the density of the coating source is greater than 80 % of the theoretical density.

7. Coating source according to Claim 6, **characterized in that** the dopant is a metal, a semimetal, a metal oxide, a semimetal oxide, a metal nitride, a semimetal nitride, a metal boride, a semimetal boride, a metal silicide or a semimetal silicide.

8. Coating source according to Claim 6 or 7, **characterized in that** the dopant is an element from the group consisting of titanium, vanadium, chromium, zirconium, niobium, molybdenum, hafnium, tantalum, tungsten, silicon or an oxidic, nitridic, boridic or silicidic compound of an element from the group consisting of titanium, vanadium, chromium, zirconium, niobium, molybdenum, hafnium, tantalum, tungsten or an oxidic, nitridic or boridic compound of silicon.

9. Coating source according to any of Claims 6 to 8, **characterized in that** the average spacing of the dopant-containing particles is less than 50 µm.

10. Coating source according to any of Claims 6 to 9, **characterized in that** the microstructure has an oriented structure.

11. Use of a coating source according to any of Claims 6 to 10 for the deposition of doped carbon layers.

## Revendications

1. Procédé pour la préparation d'une source de revêtement pour le dépôt physique en phase vapeur de couches carbonées dopées, la source de revêtement présentant du carbone comme matériau de matrice en une proportion d'au moins 75% en mole et au moins un dopant en une proportion entre 1% en mole et 25% en mole, le dopant étant incorporé sous forme particulaire finement divisée dans la matrice carbonée et la structure de la source de revêtement présentant au moins deux phases cristallographiques différentes et au moins une phase présentant le dopant, la source de revêtement présentant au moins 80% de densité théorique, **caractérisé en ce que** le procédé comprend au moins les étapes de préparation suivantes :
- préparation d'un mélange de poudre constitué par de la poudre contenant du carbone et de la poudre contenant le dopant
- frittage du mélange de poudre par frittage avec passage direct de courant ou par pressage à chaud à des températures de 1300°C à 3000°C et une pression de 5 MPa à 50 MPa
- usinage mécanique du corps moulé fritté en une source de revêtement

2. Procédé selon la revendication 1, **caractérisé en ce que** le dopant est un métal, un semi-métal, un oxyde métallique, un semi-oxyde métallique, un nitrure métallique, un semi-nitrure métallique, un borure métallique, un semi-borure métallique, un siliciure métallique ou un semi-siliciure métallique.

3. Procédé selon la revendication 1 ou 2, **caractérisé en ce que** le dopant est un élément du groupe formé par le titane, le vanadium, le chrome, le zirconium, le niobium, le molybdène, le hafnium, le tantale, le tungstène, le silicium, un composé de type oxyde, nitrure, borure ou siliciure d'un élément du groupe formé par le titane, le vanadium, le chrome, le zirconium, le niobium, le molybdène, le hafnium, le tantale, le tungstène ou un composé de type oxyde, nitrure ou borure du silicium.

4. Procédé selon l'une quelconque des revendications précédentes, **caractérisé en ce que** la poudre contenant du carbone et/ou la poudre contenant un dopant présente une grosseur moyenne de particule d'un diamètre inférieur à 50 µm.

5. Procédé selon l'une quelconque des revendications précédentes, **caractérisé en ce que** le corps moulé fritté est traité thermiquement après le procédé de frittage pour la graphitisation sans pression appliquée en plus à des températures dans la plage de 2000°C à 3000°C.

6. Source de revêtement pour le dépôt physique en phase vapeur pour la préparation de couches carbonées dopées, qui est préparée par frittage à partir de composants sous forme de poudre et qui présente du carbone comme matériau de matrice en une proportion d'au moins 75% en mole et au moins un dopant en une proportion entre 1% en mole et 25% en mole, le dopant étant incorporé sous forme particulaire finement divisée dans la matrice carbonée et la structure de la source de revêtement présentant au moins deux phases cristallographiques différentes, au moins une phase présentant le dopant et la source de revêtement présentant une densité d'au moins 80% de densité théorique.

7. Source de revêtement selon la revendication 6, **caractérisée en ce que** le dopant est un métal, un semi-métal, un oxyde métallique, un semi-oxyde métallique, un nitrure métallique, un semi-nitrure métallique, un borure métallique, un semi-borure métallique, un siliciure métallique ou un semi-siliciure métallique.

8. Source de revêtement selon la revendication 6 ou 7, **caractérisée en ce que** le dopant est un élément du groupe formé par le titane, le vanadium, le chrome, le zirconium, le niobium, le molybdène, le hafnium, le tantale, le tungstène, le silicium ou un composé de type oxyde, nitrure, borure ou siliciure d'un élément du groupe formé par le titane, le vanadium, le chrome, le zirconium, le niobium, le molybdène, le hafnium, le tantale, le tungstène ou un composé de type oxyde, nitrure ou borure du silicium.

9. Source de revêtement selon l'une quelconque des revendications 6 à 8, **caractérisée en ce que** la distance moyenne entre les particules contenant un dopant est inférieure à 50 µm.

10. Source de revêtement selon l'une quelconque des revendications 6 à 9, **caractérisée en ce que** la structure présente une structure orientée.

11. Utilisation d'une source de revêtement selon l'une quelconque des revendications 6 à 10 pour le dépôt de couches carbonées dopées.
